(19) Europäisches Patentamt

European Patent Office

Office européen des brevets

(11) **EP 0 991 996 B1**

(12) **EUROPEAN PATENT SPECIFICATION**

(45) Date of publication and mention
of the grant of the patent:
**27.03.2002 Bulletin 2002/13**

(51) Int Cl.⁷: **G06F 11/273**, G01R 31/319,
G06F 1/10, H01P 1/202

(21) Application number: **97930174.4**

(22) Date of filing: **23.06.1997**

(86) International application number:
**PCT/US97/10753**

(87) International publication number:
**WO 98/59294 (30.12.1998 Gazette 1998/52)**

(54) **JITTER REDUCTION MODULE**

JITTERREDUKTIONSSCHALTUNG

MODULE DE REDUCTION DE FRETILLEMENT

(84) Designated Contracting States:
**DE FR GB IE IT NL**

(43) Date of publication of application:
**12.04.2000 Bulletin 2000/15**

(73) Proprietor: **TERADYNE, INC.**
**Boston, Massachusetts 02118 (US)**

(72) Inventor: **XU, Fang**
**F-78180 Montigny le Bretonneux (FR)**

(74) Representative:
**Luckhurst, Anthony Henry William**
**MARKS & CLERK,**
**57-60 Lincoln's Inn Fields**
**London WC2A 3LS (GB)**

(56) References cited:
**WO-A-86/05032          DE-A- 19 625 185**

• **MATTHAEI, YOUNG, JONES: "Microwave Filters, Impedance Matching Networks and Coupling Structures" 1964 , MCGRAW HILL XP002057577 see page 163 - page 168 see page 214 - page 217**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

This invention relates generally to automatic test equipment, and more particularly to reducing jitter in a test system clock.

Automatic test equipment, generally known as testers, are commonly used in the electronics industry for determining whether electronic components, semiconductor devices, or printed circuit board assemblies contain manufacturing defects. Further, testers generally consist of computerized control circuitry, driver and receiver channels, and tester pins, which connect nodes of a device under test (DUT) to the driver and receiver channels.

During a typical test session, the driver channels apply test signals to the DUT, and the receiver channels detect output signals produced by the DUT in response to the test signals. The output signals are then generally evaluated by comparing them with expected response signals, which would be produced by a properly functioning device.

An important feature of testers is the ability to apply the test signals and to detect the output signals at precisely specified times. Accordingly, testers typically include timing generators, which generate timing signals known as "edges." For example, a first specified edge may cause a driver channel to start applying a test signal, while a second specified edge may cause the driver channel to stop applying the test signal. Similarly, a third specified edge may cause a receiver channel to start detecting output signals, while a fourth specified edge may cause the receiver channel to stop detecting the output signals.

Another important feature of testers is the ability to test the DUT at fast data rates. This is because, in many cases, faults or errors in the DUT can only be detected when the DUT is exercised at data rates that either meet or exceed the operating speed of the DUT.

However, we have recognized that as the data rates of testers increase, it becomes more difficult to specify precisely the times when the edges occur. One reason for this is that jitter, which generally causes the phase of signals to vary over time, usually becomes more prominent with increasing data rates. Such jitter is inherent in test system clocks used by most timing generators.

One way of reducing jitter in the test system clocks is through filtering. In particular, a band-pass filter, centered at the fundamental frequency of a clock, has been used to attenuate jitter components of the clock. However, the band-pass filter also generally attenuates higher-order harmonics of the clock. This means that although the jitter components might be sufficiently reduced, the overall characteristics of the clock may be changed. For example, the attenuation of higher-order harmonics typically reduces the slope of a clock signal at transition regions between high and low voltage levels.

Another way of reducing jitter is to regenerate the clock using a phase-locked loop, which typically includes a voltage-controlled oscillator, a low-pass filter, and a feedback circuit such as shown in DE-A-196 25 185. However, jitter in the regenerated clock is normally dependent upon the quality of the voltage-controlled oscillator. This tends to complicate the design of the phase-locked loop, thereby increasing the cost of testers.

It would therefore be desirable to have a method of reducing jitter in a test system clock that does not alter characteristics of the clock such as voltage level, duty cycle, and overall shape of the clock. It would also be desirable to have a method of reducing jitter that is inexpensive and easy to implement.

With the foregoing background in mind, it is an object of the invention to reduce jitter components of a test system clock in a tester.

Another object of the invention is to provide an apparatus for reducing test system clock jitter in a tester that is inexpensive and easy to implement.

A first aspect of the present invention provides automatic test equipment including a jitter reduction module, the jitter reduction module comprising a first transmission line for carrying a test system clock, the first transmission line having an end connected to a first tuning stub, wherein the first tuning stub has either an open or a short circuit termination, characterised in that: the jitter reduction module further includes a second transmission line, a second tuning stub, and a radio frequency transformer RF, wherein the RF transformer includes a primary coil and a secondary coil, wherein the end of the first transmission line connected to the first tuning stub is connected to one end of the primary coil, wherein an end of the second transmission line is connected to an opposite end of the primary coil, and wherein the second tuning stub is connected to the secondary coil.

A second aspect of the present invention provides a clock jitter reduction module, comprising a first transmission line and a second transmission line: said second transmission line for inputting a clock signal; further comprising a radio frequency transformer RF having a primary and a secondary coil, one end of the primary coil being coupled to said second transmission line; said first transmission line coupled to an opposite end of the primary coil, for outputting a clock signal with reduced jitter; further comprising a first tuning stub having an open-circuited termination coupled to the opposite end of the primary coil; and a second tuning stub coupled to the secondary coil.

In a preferred embodiment, the first tuning stub is open-circuited and has an electrical length that is equal to one-half of the wavelength of the test system clock.

The jitter reduction module may include a second port for providing a jitter output. The RF transformer is preferably a balun having a transforming ratio of 1:1, and a ferrite rod core.

Preferably, the second tuning stub is short circuited and has an electrical length that is equal to one-half of the wavelength of the test system clock.

Still further objects and advantages will become apparent from a consideration of the ensuing description and drawings.

BRIEF DESCRIPTION OF THE DRAWINGS

The invention will be better understood by reference to the following more detailed description and accompanying drawings in which

Figure 1 is a partial block diagram of a tester incorporating a jitter reduction module in accordance with the present invention,

Figure 2 is a block diagram of an embodiment of the jitter reduction module of the invention, for use in the tester of Figure 1.

DESCRIPTION OF THE PREFERRED EMBODIMENT

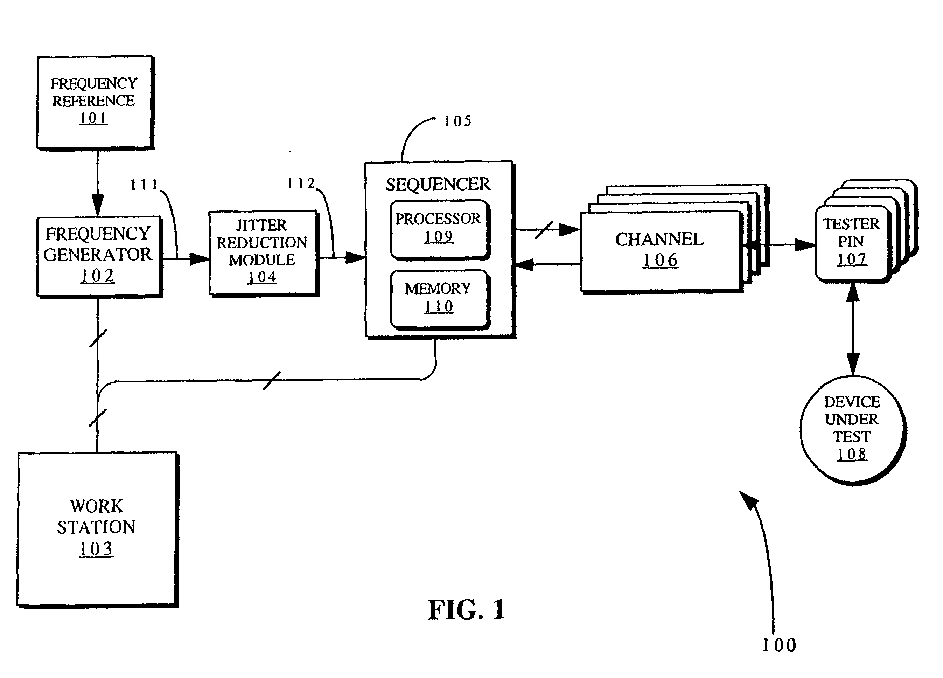

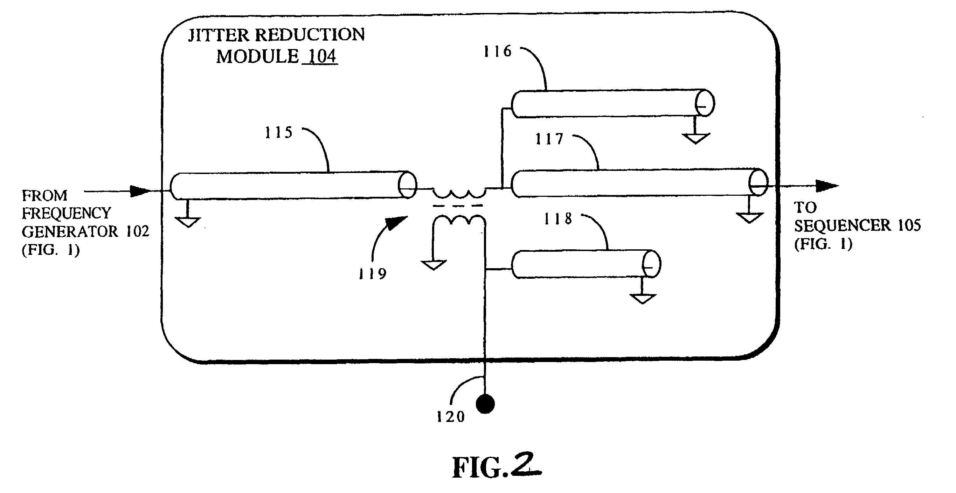

FIG. 1 depicts a partial block diagram of tester 100, which incorporates jitter reduction module 104 in accordance with the present invention.

In a typical test configuration, a test engineer develops test programs on computer work station 103. The test programs generally include a series of test vectors. The test engineer also typically enters commands on computer work station 103, including commands for starting a test or specifying operating parameters. In particular, the test engineer might specify a frequency of a test system clock, which is subsequently produced by frequency generator 102, thereby specifying a test cycle. The frequency of the test system clock is typically in the RF band; i.e., from 20 MHz to 800 MHz.

Further, frequency generator 102 is coupled to both frequency reference 101, which provides a reference for the test system clock, and jitter reduction module 104, which is coupled to vector sequencer 105. Jitter reduction module 104 will be discussed in greater detail below.

The test engineer then typically enters a command on computer work station 103 for loading the test programs into memory 110 included in vector sequencer 105. For example, during a specified test cycle, processor 109, which is also included in vector sequencer 105, sequentially reads the test vectors from memory 110, and then sends data values, timing information, and format information to channel 106. As shown, channel 106 is but one of a plurality of channels included in tester 100. Further, tester pin 107, which is also one of a plurality of tester pins, connects channel 106 to one of the nodes of device under test (DUT) 108. The number of tester pins is generally equal to the number of channels in tester 100.

The data values are typically logical values of binary digits 0 and 1, and the format information generally indicates whether the data values are applied to or captured at certain nodes of DUT 108. Also, the timing information generally indicates when the data values are applied or captured, relative to the beginning of the specified test cycle. Accordingly, channel 106 includes circuitry (not shown) for either applying test data to DUT 108 or capturing output data produced by DUT 108 in response to the test data.

Tester 100 then compares the captured output data with expected data, which is also typically stored in memory 110. The comparing is usually implemented in software using processor 109, which generally responds to a series of programmed steps. If the captured output data matches the expected data, then tester 100 would normally indicate that DUT 108 is functioning properly.

Frequency reference 101, frequency generator 102, computer work station 103, vector sequencer 105, channel 106, and tester pin 107 represent components that are included in a conventional tester. The construction of each of these components are therefore known to those skilled in this art. It follows that specific implementations of these components are not critical to the present invention.

FIG.2 shows a block diagram of an embodiment of the jitter reduction module 104 in accordance with the invention. Frequency generator 102 once again provides jitter reduction module 104 with the test system clock on line 115. In the preferred embodiment, line 115 is a coaxial cable having a center signal conductor for carrying the test system clock, and a grounded outer conductor.

The test system clock on line 115 is introduced at one end of a primary coil of RF transformer 119. which is also commonly known as a transmission line transformer. In the preferred embodiment, RF transformer 119 is a balun having a transforming ratio of 1:1, and a ferrite rod core, thereby making the balun linear. The transforming ratio of 1:1 is chosen for maximizing the bandwidth of RF transformer 119.

Lines 116 and 117, which are also coaxial cables having grounded outer conductors in the preferred embodiment, are coupled to RF transformer 119 at the other end of the primary coil. Line 116 is preferably an open-circuited tuning stub having an electrical length that is equal to one-half of the wavelength, $\lambda_c$, of the test system clock. Further, line 117 provides a test system clock with reduced jitter to vector sequencer 105.

The test system clock is induced in a secondary coil of RF transformer 119. One end of the secondary coil is grounded, while the other end of the secondary coil provides jitter output 120 and is coupled to line 118, which is also preferably a coaxial cable with a grounded outer conductor. RF transformer 119 electrically isolates jitter output 120 from line 116, and lines 115 and 117, which are part of the signal path for the test system clock.

Further, lines 115, 116, 117, and 118 each have a characteristic impedance, $Z_0$, for the preferred embodiment shown. This simplifies the impedance and gain calculations that follow. However, the invention described herein is meant to include those embodiments in which lines corresponding to lines 115, 116, 117, and 118 have any appropriate characteristic impedance.

Jitter reduction module 104 uses both lines 116 and 118 as tuning stubs for transmission lines 115 and 117. In particular, it was described above that the impedance of an open-circuited tuning stub, more specifically line 116, as a function of frequency, may be expressed as

$$Z_{116,OPEN}(f) = -j(Z_0)\cot[(2\pi f/f_c\lambda_c)l_{116}],$$

where fc is the fundamental frequency of the test system clock, and $l_{116}$ is the electrical length of line 116, which is preferably equal to one-half of the wavelength, $\lambda_c$, of the test system clock. It follows that

$$Z_{116,OPEN}(f) = -j(Z_0)\cot[(f/f_c)\pi].$$

In the preferred embodiment, line 118 is a short-circuited tuning s,tub. It is known that the impedance of a short-circuiced stub, more specifically line 118, may be expressed as

$$Z_{118,SHORT}(f) = j(Z_0)\tan[2\pi f/f_c\lambda_c)l_{118}].$$

Further, line 118 preferably has an electrical length, $l_{118}$, that is equal to $\lambda_c/2$. Accordingly,

$$Z_{118,SHORT}(f) = j(Z_0)\tan[(f/f_c)\pi].$$

The gain at the test system clock output of jitter reduction module 104 may be expressed as

$$A_c = (Z_0Z_{116}+Z_{116}Z_{118})/(Z_0Z_{116}+Z_0Z_{118}+2Z_{116}Z_{118}).$$

Also, the gain at jitter output 120 may be expressed as

$$A_J = (Z_0Z_{118}+Z_{116}Z_{118})/(Z_0Z_{116}+Z_0Z_{118}+2Z_{116}Z_{118}).$$

Consequently, $Z_{116,OPEN}(f)$ approaches successive maxima, and $Z_{118,SHORT}(f)$ approaches null, as the frequency, f, approaches respective frequencies $f_c$, $2f_c$, $3f_c$, and so on. Further, $Z_{116,OPEN}(f)$ approaches null, and $Z_{118,SHORT}(f)$ approaches successive maxima, as f approaches respective frequencies $(1/2)f_c$, $(3/2)f_c$, $(5/2)f_c$, and so on.

This means that the gain at the test system clock output, $A_c$, is approximately unity at respective frequencies $f_c$, $2f_c$, $3f_c$, and so on, which are the fundamental frequency and higher-harmonics of the test system clock. Also, $A_c$ is approximately null at respective frequencies $(1/2)f_c$, $(3/2)f_c$, $(5/2)f_c$, and so on, which normally constitute jitter. Accordingly, line 117 passes a test system clock with reduced jitter to sequencer 105 (FIG. 1).

This also means that the gain at jitter output 120, $A_J$, is approximately unity at respective frequencies $(1/2)f_c$, $(3/2)f_c$, $(5/2)f_c$, and so on. Additionally, $A_J$ is approximately null at respective frequencies $f_c$, $2f_c$, $3f_c$, and so on. Accordingly, jitter output 120 provides substantially all of the jitter derived from the test system clock.

In still another embodiment, line 118 is an open-circuited tuning stub having an electrical length that is equal to $\lambda_c/4$. Accordingly,

**EP 0 991 996 B1**

$$Z_{118,OPEN}(f) = -j(Z_0)\cot[(f/2f_c)\pi].$$

Consequently, $Z_{118,OPEN}(f)$ is non-zero as f approaches respective frequencies $(1/2)f_c$, $(3/2)f_c$, $(5/2)f_c$, and so on. Further, $Z_{118,OPEN}(f)$ approaches null as the frequency, f, approaches $f_c$, $3f_c$, $5f_c$, $7f_c$, and so on, which are the fundamental frequency and odd harmonics of the test system clock.

As a result, line 117 passes a test system clock with more jitter than the preferred embodiment described above, which included line 118 having an electrical length, $\lambda_c/2$, and an impedance, $Z_{118,SHORT}(f)$. However, this embodiment may have advantages of less weight and smaller signal loss for some lower frequency applications.

Another advantage of jitter reduction module 104 is that the jitter provided by jitter output 120 can be measured and analyzed by the test engineer. This is sometimes useful in evaluating the quality of the test system clock provided by line 117.

Having described one embodiment, alternative embodiments or variations might be made. For example, lines 116, and 118 may be configured with different electrical lengths for achieving optimal weight, signal loss, and jitter reduction for various applications.

Also, alternative embodiments of RF transformer 119 may be used for achieving optimal isolation between line 117, which is the test system clock output, and jitter output 120.

Also, the embodiment of jitter reduction module 104 shown in FIG. 2 may be combined with the prior art apparatus for reducing jitter, which regenerated the test system clock using a phase-locked loop. In particular, jitter reduction module 104 may be coupled to the output of the phase-locked loop for further reducing any jitter that might remain in the regenerated clock.

**Claims**

1. Automatic test equipment (100) including a jitter reduction module (104), the jitter reduction module comprising a first transmission line (117) for carrying a test system clock, the first transmission line having an end connected to a first tuning stub (116), wherein the first tuning stub has either an open or a short circuit termination, **characterized in that**:

   the jitter reduction module further includes a second transmission line (115), a second tuning stub (118), and a radio frequency transformer RF (119),
   wherein the RF transformer includes a primary coil and a secondary coil,
   wherein the end of the first transmission line (117) connected to the first tuning stub is connected to one end of the primary coil,
   wherein an end of the second transmission line (115) is connected to an opposite end of the primary coil, and
   wherein the second tuning stub (118) is connected to the secondary coil

2. The automatic test equipment as recited in claim 1,
   wherein the RF transformer is a 1:1 balun.

3. The automatic test equipment as recited in claim 1,
   wherein the first tuning stub is a coaxial cable with an open-circuited termination.

4. The automatic test equipment as recited in claim 3,
   wherein the first tuning stub has an electrical length equal to one-half of the wavelength of the test system clock.

5. The automatic test equipment as recited in claim 1,
   wherein the second tuning stub is a coaxial cable with a short-circuited termination.

6. The automatic test equipment as recited in claim 5,
   wherein the second tuning stub has an electrical length equal to one-half of the wavelength of the test system clock.

7. The automatic test equipment as recited in claim 1,
   wherein the second tuning stub is a coaxial cable with an open-circuited termination.

8. The automatic test equipment as recited in claim 7, wherein the second tuning stub has an electrical length equal to one-quarter of the wavelength of the test system clock.

9. A clock jitter reduction module (104), comprising a first transmission line (117) and a second transmission (115):

   (a) said second transmission line (115) for inputting a clock signal; further comprising
   (b) a radio frequency transformer RF (119) having a primary and a secondary coil, one end of the primary coil being coupled to said second transmission line (115);
   (c) said first transmission line (117) coupled to an opposite end of the primary coil, for outputting a clock signal with reduced jitter; further comprising
   (d) a first tuning stub (116) having an open-circuited termination coupled to the opposite end of the primary coil; and
   (e) a second tuning stub (118) coupled to the secondary coil.

10. A clock jitter reduction module as claimed in claim 9, wherein the first and second transmission lines (117, 115) and the first and second tuning stubs (116, 118) are coaxial cables.

11. The clock jitter reduction module as recited in claim 10, wherein the RF transformer is a 1:1 balun.

12. The clock jitter reduction module as recited in claim 10, wherein the first tuning stub (116) has an electrical length equal to one-half of the wavelength of the clock signal.

13. The clock jitter reduction module as recited in claim10 wherein the second tuning stub (118) has a short-circuited termination.

14. The clock jitter reduction module as recited in claim 13, wherein the second tuning stub (118) has an electrical length equal to one-half of the wavelength of the clock signal.

15. The clock jitter reduction module as recited in claim 10, wherein the second tuning stub (118) has an open-circuited termination.

16. The clock jitter reduction module as recited in claim 15, wherein the second tuning stub (118) has an electrical length equal to one-quarter of the wavelength of the clock signal.


**Patentansprüche**

1. Automatisches Testgerät (100) mit einem Jitter-(Flackern-)Reduktionsmodul (104), wobei das Jitter-Reduktionsmodul eine erste Übertragungsleitung (117) zum Führen eines Testsystemtakts umfasst, wobei die erste Übertragungsleitung ein Ende aufweist, das mit einer ersten Abstimm-Abzweigungsleitung (116) verbunden ist, wobei die erste Abstimm-Abzweigungsleitung entweder einen offenen oder einen kurzgeschlossenen Abschluss aufweist, **dadurch gekennzeichnet, dass**:

   das Jitter-Reduktionsmodul ferner eine zweite Übertragungsleitung (115), eine zweite Abstimm-Abzweigungsleitung (118) und einen Funkfrequenz-Transformator RF (119) umfasst,
   wobei der RF-Transformator einer Primärspule und eine Sekundärspule umfasst,
   wobei das Ende der ersten Übertragungsleitung (117), die mit der ersten Abstimm-Abzweigungsleitung verbunden ist, mit einem Ende der Primärspule verbunden ist,
   wobei ein Ende der zweiten Übertragungsleitung (115) mit einem entgegengesetzten Ende der Primärspule verbunden ist, und
   wobei die zweite Abstimm-Abzweigungsleitung (118) mit der Sekundärspule verbunden ist.

2. Automatisches Testgerät nach Anspruch 1, wobei der RF-Transformator ein 1;1 Symmetrier-Übertrager ist.

3. Automatisches Testgerät nach Anspruch 1, wobei die erste Abstimm-Abzweigungsleitung ein Koaxialkabel mit einem Abschluss mit einer offenen Schaltung ist.

4. Automatisches Testgerät nach Anspruch 3, wobei die erste Abstimm-Abzweigungsleitung eine elektrische Länge aufweist, die gleich zu einer Hälfte der Wellenlänge des Testsystemtakts ist.

5. Automatisches Testgerät nach Anspruch 1, wobei die zweite Abstimm-Abzweigungsleitung ein Koaxialkabel mit einem kurzgeschlossenen Abschluss ist.

6. Automatisches Testgerät nach Anspruch 5, wobei die zweite Abstimm-Abzweigungsleitung eine elektrische Länge aufweist, die gleich zu einer Hälfte der Wellenlänge des Testsystemtakts ist.

7. Automatisches Testgerät nach Anspruch 1, wobei die zweite Abstimm-Abzweigungsleitung ein Koaxialkabel mit einem Abschluss einer offenen Schaltung ist.

8. Automatisches Testgerät nach Anspruch 7, wobei die zweite Abstimm-Abzweigungsleitung eine elektrische Länge aufweist, die gleich zu einem Viertel der Wellenlänge des Testsystemtakts ist.

9. Taktjitter-Reduktionsmodul (104), umfassend eine erste Übertragungsleitung (117) und eine zweite Übertragungsleitung (115):

   (a) wobei die zweite Übertragungsleitung (115) zum Eingeben eines Taktsignals vorgesehen ist; ferner umfassend
   (b) einen Funkfrequenz-Transformator RF (119), mit einer Primär- und einer Sekundärspule, wobei ein Ende der Primärspule mit der zweiten Übertragungsleitung (115) gekoppelt ist;
   (c) wobei die erste Übertragungsleitung (117) mit einem entgegengesetzten Ende der Primärspule gekoppelt ist, zum Ausgeben eines Taktsignals mit einem reduzierten Jitter; ferner umfassend
   (d) eine erste Abstimm-Abzweigungsleitung (116) mit einem Abschluss einer offenen Schaltung, der mit dem entgegengesetzten Ende der Primärspule gekoppelt ist; und
   (e) eine zweite Abstimm-Abzweigungsleitung (118), die mit der Sekundärspule gekoppelt ist.

10. Taktjitter-Reduktionsmodul nach Anspruch 9, wobei die ersten und zweiten Übertragungsleitungen (117, 115) und die ersten und zweiten Abstimm-Abzweigungsleitungen (116, 118) Koaxialkabel sind.

11. Taktjitter-Reduktionsmodul nach Anspruch 10, wobei der RF-Transformator ein 1:1 Symmetrier-Übertrager ist,

12. Taktjitter-Reduktionsmodul nach Anspruch 10, wobei die erste Abstimm-Abzweigungsleitung (116) eine elektrische Länge aufweist, die gleich zu einer Hälfte der Wellenlänge des Taktsignals ist.

13. Taktjitter-Reduktionsmodul nach Anspruch 10, wobei die zweite Abstimm-Abzweigungsleitung (118) einen kurzgeschlossenen Abschluss aufweist.

14. Taktjitter-Reduktionsmodul nach Anspruch 13, wobei die zweite Abstimm-Abzweigungsleitung (118) eine elektrische Länge aufweist, die gleich zu einer Hälfte der Wellenlänge des Taktsignals ist.

15. Taktjitter-Reduktionsmodul nach Anspruch 10, wobei die zweite Abstimm-Abzweigungsleitung (118) einen Abschluss mit einer offenen Schaltung aufweist.

16. Taktjitter-Reduktionsmodul nach Anspruch 15, wobei die zweite Abstimm-Abzweigungsleitung (118) eine elektrische Länge aufweist, die gleich zu einem Viertel der Wellenlänge des Taktsignals ist.

**Revendications**

1. Equipement de test automatique (100) comprenant un module de réduction de gigue (104), le module de réduction de gigue comprenant une première ligne de transmission (117) pour acheminer une horloge de système de test, la première ligne de transmission ayant une extrémité connectée à un premier tronçon de ligne d'accord (116), le premier tronçon de ligne d'accord ayant une terminaison en circuit ouvert ou en court-circuit, **caractérisé en ce que** :

   le module de réduction de gigue comprend en outre une seconde ligne de transmission (115), un second tronçon de ligne d'accord (118) et un transformateur radiofréquence RF (119),
   le transformateur RF comprend une bobine primaire et une bobine secondaire,
   l'extrémité de la première ligne de transmission (117) connectée au premier tronçon de ligne d'accord est connectée à une extrémité de la bobine primaire,

une extrémité de la seconde ligne de transmission (115) est connectée à une extrémité opposée de la bobine primaire, et

le second tronçon de ligne d'accord (118) est connecté à la bobine secondaire.

2. L'équipement de test automatique selon la revendication 1,
   dans lequel le transformateur RF est un transformateur symétrique-dissymétrique 1:1.

3. L'équipement de test automatique selon la revendication 1,
   dans lequel le premier tronçon de ligne d'accord est un câble coaxial avec une teminaison en circuit ouvert.

4. L'équipement de test automatique selon la revendication 3,
   dans lequel le premier tronçon de ligne d'accord a une longueur électrique égale à la moitié de la longueur d'onde de l'horloge de système de test.

5. L'équipement de test automatique selon la revendication 1,
   dans lequel le second tronçon de ligne d'accord est un câble coaxial avec une terminaison en court-circuit.

6. L'équipement de test automatique selon la revendication 5,
   dans lequel le second tronçon de ligne d'accord a une longueur électrique égale à la moitié de la longueur d'onde de l'horloge de système de test.

7. L'équipement de test automatique selon la revendication 1,
   dans lequel le second tronçon de ligne d'accord est un câble coaxial avec une terminaison en circuit ouvert.

8. L'équipement de test automatique selon la revendication 7, dans lequel le second tronçon de ligne d'accord a une longueur électrique égale au quart de la longueur d'onde de l'horloge de système de test.

9. Un module de réduction de gigue d'horloge (104), comprenant une première ligne de transmission (117) et une seconde ligne de transmission (115);

   (a) la seconde ligne de transmission (115) étant destinée à l'application d'un signal d'horloge; comprenant en outre

   (b) un transformateur radiofréquence RF (119) ayant une bobine primaire et une bobine secondaire, une extrémité de la bobine primaire étant couplée à la seconde ligne de transmission (115);

   (c) la première ligne de transmission (117) étant couplée à une extrémité opposée de la bobine primaire, pour émettre un signal d'horloge avec une gigue réduite; comprenant en outre

   (d) un premier tronçon de ligne d'accord (116) ayant une terminaison en circuit ouvert couplé à l'extrémité opposée de la bobine primaire; et

   (e) un second tronçon de ligne d'accord (118) couplé à la bobine secondaire.

10. Le module de réduction de gigue d'horloge selon la revendication 9, dans lequel les première et seconde lignes de transmission (117, 115) et les premier et second tronçons de ligne d'accord (116, 118) sont des câbles coaxiaux.

11. Le module de réduction de gigue d'horloge selon la revendication 10, dans lequel le transformateur RF est un transformateur symétrique-dissymétrique 1:1.

12. Le module de réduction de gigue d'horloge selon la revendication 10, dans lequel le premier tronçon de ligne d'accord (116) a une longueur électrique égale à la moitié de la longueur d'onde du signal d'horloge.

13. Le module de réduction de gigue d'horloge selon la revendication 10, dans lequel le second tronçon de ligne d'accord (118) a une terminaison en court-circuit.

14. Le module de réduction de gigue d'horloge selon la revendication 13, dans lequel le second tronçon de ligne d'accord (118) a une longueur électrique égale à la moitié de la longueur d'onde du signal d'horloge.

15. Le module de réduction de gigue d'horloge selon la revendication 10, dans lequel le second tronçon de ligne d'accord (118) a une terminaison en circuit ouvert.

**16.** Le module de réduction de gigue d'horloge selon la revendication 15, dans lequel le second tronçon de ligne d'accord (118) a une longueur électrique égale au quart de la longueur d'onde du signal d'horloge.

FREQUENCY REFERENCE 101

FREQUENCY GENERATOR 102

111

JITTER REDUCTION MODULE 104

112

105

SEQUENCER

PROCESSOR 109

MEMORY 110

CHANNEL 106

TESTER PIN 107

DEVICE UNDER TEST 108

WORK STATION 103

FIG. 1

100

EP 0 991 996 B1

FIG. 2

EP 0 991 996 B1